# EUROPÄISCHE PATENTSCHRIFT

(11) **EP 0 915 498 B1**
(45) Veröffentlichungstag und Bekanntmachung des Hinweises auf die Patenterteilung: **08.08.2001**
(21) Anmeldenummer: 98119005.1
(22) Anmeldetag: 08.10.1998
(51) Int. Cl.: H01L 21/00

(54) **Verfahren und Vorrichtung zum Erkennen einer Fehllage einer Halbleiterscheibe**
Apparatus and method for detecting a position error of a wafer
Dispositif et méthode pour détecteur une erreur de positionnement d'une plaquette semiconductrice

(30) Priorität: 30.10.1997 DE 19748088
(43) Veröffentlichungstag der Anmeldung: 12.05.1999
(73) Patentinhaber: Wacker Siltronic Gesellschaft für Halbleitermaterialien Aktiengesellschaft, 84489 Burghausen (DE)
(72) Erfinder: Brenninger, Georg, 84564 Oberbergkirchen (DE); Sedlmeier, Wolfgang, 83119 Obing (DE); Fürfanger, Martin, 85643 Steinhöring (DE); Hansson, Per-Ove Dr., 84524 Neuötting (DE)
(74) Vertreter: Rimböck, Karl-Heinz, Dr.

(56) Entgegenhaltungen:
- US-A- 4 697 089
- US-A- 5 374 315
- PATENT ABSTRACTS OF JAPAN vol. 095, no. 010, 30. November 1995 (1995-11-30) -& JP 07 169823 A (KOKUSAI ELECTRIC CO LTD), 4. Juli 1995 (1995-07-04)

## Beschreibung

Gegenstand der Erfindung ist ein Verfahren zum Erkennen einer Fehllage einer Halbleiterscheibe während einer Hochtemperatur-Behandlung der Halbleiterscheibe in einer von IR-Strahlern beheizten Quarzkammer, wobei die Halbleiterscheibe auf einer rotierenden Auflage liegt und mit Hilfe eines Regelsystems auf einer bestimmten Temperatur gehalten wird. Gegenstand der Erfindung ist auch eine Vorrichtung zur Durchführung des Verfahrens.

Eine Halbleiterscheibe wird einer Hochtemperatur-Behandlung in einer Quarzkammer unterzogen, wenn beispielsweise beabsichtigt ist, die Halbleiterscheibe zu tempem ("annealing", "rapid thermal annealing", "rapid thermal processing (RTP)"), zu dotieren oder eine Materialschicht auf einer oder beiden Seiten der Halbleiterscheibe abzuscheiden ("chemical vapour deposition (CVD)", "atmospheric pressure CVD (ACVD)", "reduced pressure CVD (RCVD)", "epitaxy"). Zu diesem Zweck muß die Halbleiterscheibe auf einer Auflage ("suszeptor") liegen. Die Auflage wird während der Behandlung gedreht, um eine möglichst gleichmäßige Behandlung der Halbleiterscheibe sicherzustellen.

In der US-5,374,315 ist eine für CVD-Verfahren geeignete Vorrichtung offenbart, die einen drehbaren Substratträger mit einem Mechanismus zum Messen der Temperatur im Zentrum und an der Peripherie des Substratträgers umfaßt.

Für den Erfolg der Hochtemperatur-Behandlung ist häufig mitentscheidend, daß die Halbleiterscheibe in der vorgesehenen Position auf der Auflage liegt und diese Position auch während der Behandlung beibehält. Bereits eine geringe Fehllage der Halbleiterscheibe, die darin besteht, daß die Halbleiterscheibe nicht, wie vorgesehen, parallel zur Auflage liegt, kann unerwünschte Folgen haben. Liegt die Halbleiterscheibe beispielsweise während einer Beschichtungs-Behandlung nicht parallel zur Auflage, sondern etwas aus der parallelen Position gekippt auf der Auflage, kann die abgeschiedene Schicht ungleichmäßig dick sein. Es kann zu Kristalldefekten der Halbleiterscheibe kommen.

Häufig ist die Auflage für die Halbleiterscheibe im Randbereich erhöht. Dadurch sollen Fehllagen vermieden und ein Zentrieren der Halbleiterscheibe ermöglicht werden. Trotz solcher Vorkehrungen ist nicht sicher auszuschließen, daß die Halbleiterscheibe in unerwünschter Weise auf der Auflage zu liegen kommt. Halbleiterscheiben, die aus diesem Grund nach der Behandlung fehlerhaft sind, müssen im Anschluß an die Behandlung identifiziert und ausgesondert werden. Dieses Vorgehen ist aufwendig und unwirtschaftlich.

Mit der vorliegenden Erfindung kann diese Problematik umgangen werden. Die Erfindung zeigt einen Weg auf, wie bereits während der Behandlung einer Halbleiterscheibe erkannt werden kann, daß eine Fehllage der Halbleiterscheibe vorliegt.

Gegenstand der Erfindung ist ein Verfahren gemäß Anspruch 1 zum Erkennen einer Fehllage einer Halbleiterscheibe während einer Hochtemperatur-Behandlung der Halbleiterscheibe in einer beheizten Quarzkammer, wobei die Halbleiterscheibe auf einer rotierenden Auflage liegt und mit Hilfe eines Regelsystems auf einer bestimmten Temperatur gehalten wird.

Gegenstand der Erfindung ist auch eine Vorrichtung gemäß Anspruch 5 zur Durchführung des Verfahrens.

Bei Anwendung der Erfindung kann auf eine aufwendige Suche nach Halbleiterscheiben, die in Folge einer Fehllage während einer Hochtemperatur-Behandlung fehlerhaft sind, verzichtet werden. Solche Halbleiterscheiben werden bereits am Anfang oder während der Hochtemperatur-Behandlung identifiziert und beispielsweise im Anschluß an die Hochtemperatur-Behandlung ausgesondert. Es ist jedoch bevorzugt, die Hochtemperatur-Behandlung nach dem Feststellen einer Fehllage der Halbleiterscheibe zu unterbrechen, die Halbleiterscheibe in die gewünschte Position zu bringen und anschließend mit der Hochtemperatur-Behandlung fortzufahren. Dies ist insbesondere in solchen Fällen von Vorteil, in denen zum Zeitpunkt der Feststellung der Fehllage noch keine materielle Veränderung der Halbleiterscheibe, beispielsweise eine Beschichtung, stattgefunden hat. Als Fehllage der Halbleiterscheibe wird eine Position angesehen, die von einer waagerechten Lage der Halbleiterscheibe unzulässig abweicht. Die Feststellung einer Fehllage gelingt durch Messung von Wärmestrahlung mit Hilfe eines Pyrometers, das für diese Strahlung empfindlich ist. Das Pyrometer registriert Wärmestrahlung, die von der Halbleiterscheibe emittiert wird und Strahlungsanteile besitzt, die von den IR-Strahlern stammen und von der Halbleiterscheibe reflektiert werden. Unter stationären Bedingungen hängt die Intensiät der reflektierten und vom Pyrometer registrierten Strahlungsanteile vom entsprechenden Reflexionswinkel ab. Bei einer Fehllage der Halbleiterscheibe schwankt die Intensität der vom Pyrometer registrierten Wärmestrahlung deutlich, da der Reflexionswinkel während jeder Umdrehung der Auflage variiert. Die Oszillationen der Wärmestrahlung korellieren mit der Frequenz der Scheibenrotation. Liegt die Halbleiterscheibe hingegen während der Hochtemperatur-Behandlung in der vorgesehenen, waagerechten Position, hat dies praktisch keine Auswirkung auf den Reflexionswinkel, und es kommt zu keinen derartigen Intensitätsschwankungen. Die vom Pyrometer registrierte Strahlungsintensität ist proportional zu einer Strahlungs-Temperatur. Eine Fehllage der Halbleiterscheibe wird dann angenommen, wenn die Strahlungsintensität oder die davon abgeleitete Strahlungs-Temperatur zeitlich so stark schwankt, daß die Schwankungsbreite außerhalb eines als zulässig angesehenen Schwankungsbereiches ΔT liegt. Der als zulässig angesehene Schwankungsbereich kann durch Routineexperimente bestimmt werden. Er stimmt vorzugsweise mit einem natürlichen Schwankungsbereich überein, der sich einstellt, wenn die Halbleiterscheibe wie vorgesehen auf der Aufnahme liegt.

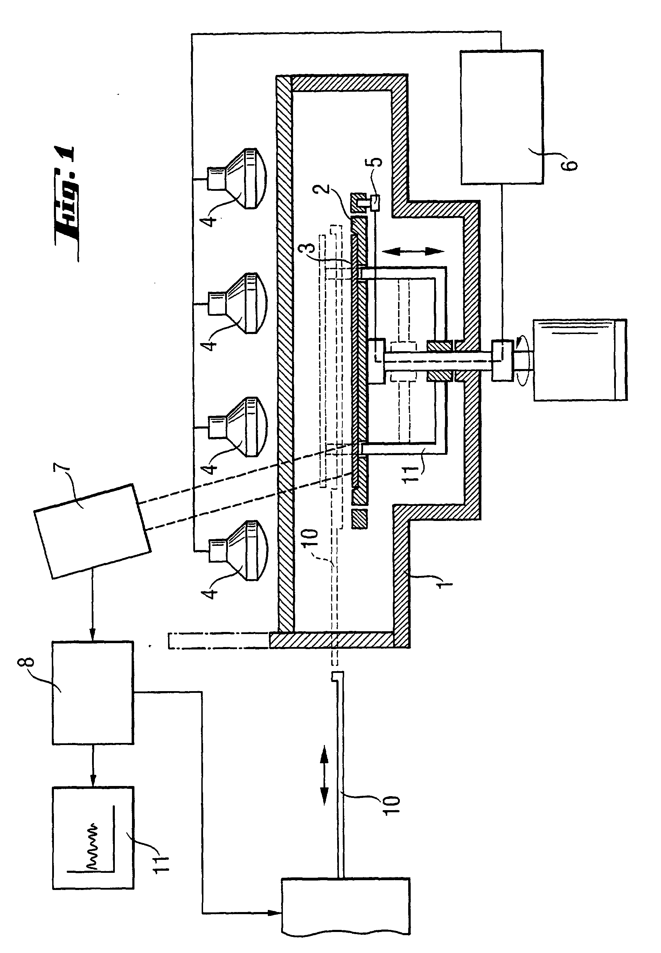

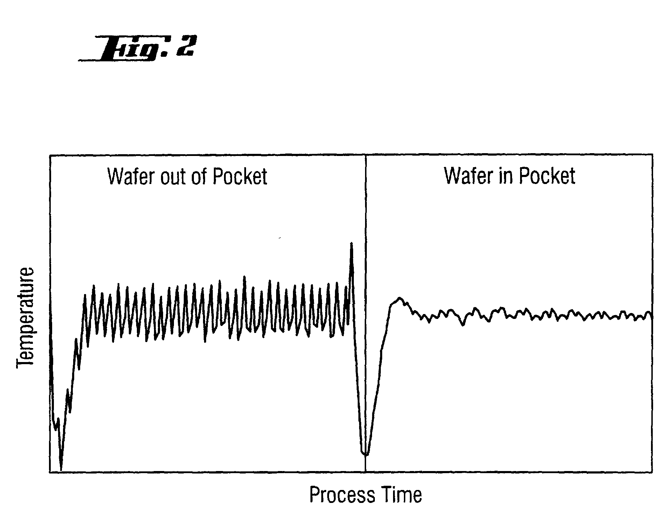

Die Erfindung wird nachfolgend an Hand von Figuren näher erläutert. Die Figur 1 zeigt schematisch eine Ausführungsform einer erfindungsgemäßen Vorrichtung. Figur 2 zeigt, daß unterschiedlich ausgeprägte Temperaturschwankungen registriert werden, je nachdem, ob eine Fehllage der Halbleiterscheibe vorliegt oder die Halbleiterscheibe wie vorgesehen auf der Auflage liegt.

Die Vorrichtung umfaßt eine gasdicht verschließbare Kammer 1 aus Quarzmaterial, nachfolgend Quarzkammer genannt, mit einer Auflage 2, auf der eine Halbleiterscheibe 3 abgelegt ist. Die Halbleiterscheibe liegt waagerecht auf der sich um eine Mittelachse drehenden Auflage. Eine davon abweichende Lage wird als Fehllage angesehen. Die Auflage kann abweichend von der Darstellung auch so ausgeführt sein, daß beide Seiten der Halbleiterscheibe für beispielsweise eine beidseitige Beschichtung frei zugänglich sind, und die Halbleiterscheibe nur im Randbereich von der Auflage abgestützt wird. Die Auflage besteht vorzugsweise aus einem Material, das die Halbleiterscheibe nicht verunreinigt und unter den Bedingungen der Hochtemperatur-Behandlung selbst nicht angegriffen wird. Ein mit Siliciumcarbid beschichteter Graphitsuszeptor ist besonders geeignet.

Außerhalb der Quarzkammer sind ein oder mehrere IR-Strahler 4 angeordnet. Die IR-Strahler, beispielsweise Halogenlampen, liefern die notwendige Strahlungsenergie, um die Halbleiterscheibe auf eine gewünschte Prozeßtemperatur, die vorzugsweise im Bereich von 600 bis 1300 °C liegt, aufzuheizen. Die Halbleiterscheibe wird mit Hilfe einer Regeleinrichtung auf einer bestimmten Temperatur gehalten. Die Regeleinrichtung besteht aus einem Temperatursensor, beispielsweise einem Thermoelement 5, das die Temperatur der Halbleiterscheibe mißt und einem Leitrechner 6, der die gemessene Temperatur mit einer gespeicherten Soll-Temperatur vergleicht und gegebenenfalls die Leistungsabgabe der IR-Strahler verändert. Die Temperatur der Halbleiterscheibe kann auch pyrometrisch gemessen werden.

Außerhalb der Quarzkammer ist ein Pyrometer 7 angeordnet, das Wärmestrahlung registriert, die von der Halbleiterscheibe emittiert wird und von der Oberfläche der Halbleiterscheibe reflektierte Strahlungsanteile aufweist, die von den IR-Strahlern stammen. Das Pyrometer 7 ist mit einer Einheit 8 verbunden, die die registrierte Wärmestrahlung auswertet und ihr eine Stahlungs-Temperatur zuordnet. Das Pyrometer registriert vorzugsweise Wärmestrahlung mit einer Wellenlänge im Bereich von 0,7 bis 1,1 µm.

Die Temperatur der Halbleiterscheibe wird auf einen bestimmten Wert eingeregelt, wobei das Pyrometer Wärmestrahlung registriert, die einer bestimmten Strahlungs-Temperatur entspricht. Die Einheit 8 erzeugt ein Signal, falls die Strahlungs-Temperatur eine Schwankungsbreite besitzt, die größer ist, als ein als zulässig erachteter Schwankungsbereich ΔT. Dies ist bei einer Fehllage der Halbleiterscheibe der Fall. Das Signal kann einen Manipulator 10 aktivieren, der daraufhin in die Quarzkammer 1 einfährt, die Halbleiterscheibe 3 aufnimmt und sie auf die Auflage 2 so zurücklegt, daß sie eine gewünschte Lage einnimmt. Die Signalverarbeitung 8 ist gegebenenfalls auch an ein Aufzeichnunggerät 11 angeschlossen, auf dem die gemessenen Temperaturen entlang einer Zeitachse dargestellt werden.

Der Darstellung in Figur 2 ist zu entnehmen, daß unterschiedlich ausgeprägte Temperaturschwankungen registriert werden, je nachdem, ob eine Fehllage der Halbleiterscheibe vorliegt (wafer out of pocket) oder die Halbleiterscheibe wie vorgesehen auf der Auflage liegt (wafer in pocket).

## Patentansprüche

1. Verfahren zum Erkennen einer Fehllage einer Halbleiterscheibe während einer Hochtemperatur-Behandlung der Halbleiterscheibe in einer beheizten Quarzkammer, wobei die Halbleiterscheibe auf einer rotierenden Auflage liegt und mit Hilfe eines Regelsystems auf einer bestimmten Temperatur gehalten wird, und Wärmestrahlung mit einem Pyrometer registriert wird, wobei
a) die Quarzkammer mit IR-Strahlern beheizt wird und Wärmestrahlung, die von der Halbleiterscheibe emittiert wird und Strahlungsanteile besitzt, die von den den IR-Strahlern stammen, mit dem Pyrometer registriert wird;
b) die Strahlungs-Temperatur der registrierten Wärmestrahlung bestimmt wird; und
c) eine Fehllage der Halbleiterscheibe angenommen wird, falls die Strahlungs-Temperatur der registrierten Wärmestrahlung zeitlich so stark schwankt, daß die Schwankungsbreite außerhalb eines als zulässig angesehenen Schwankungsbereiches ΔT liegt.

2. Verfahren nach Anspruch 1, dadurch gekennzeichnet, daß mit dem Pyrometer Wärmestrahlung mit einer Wellenlänge im Bereich von 0,7 bis 1,1 µm registriert wird.

3. Verfahren nach Anspruch 1 oder 2, dadurch gekennzeichnet, daß der als zulässig angesehene Schwankungsbereich ΔT übereinstimmt mit einem natürlichen Schwankungsbereich, der sich einstellt, wenn die Halbleiterscheibe wie vorgesehen auf der Aufnahme liegt.

4. Verfahren nach einem der Ansprüche 1 bis 3, dadurch gekennzeichnet, daß die Hochtemperatur-Behandlung bei einer Fehllage der Halbleiterscheibe unterbrochen wird, die Halbleiterscheibe in eine gewünschte Lage auf der Auflage gebracht wird, und die Hochtemperatur-Behandlung fortgesetzt wird.

5. Vorrichtung zum Erkennen einer Fehllage einer Halbleiterscheibe während einer Hochtemperatur-Behandlung der Halbleiterscheibe in einer beheizten Quarzkammer, in der die Halbleiterscheibe auf einer rotierenden Auflage liegt und mit einem Regelsystem auf einer bestimmten Temperatur gehalten wird, umfassend ein Pyrometer zum Registrieren von Wärmestrahlung, die von der Halbleiterscheibe emittiert wird, wobei die Quarzkammer von IR-Strahlem beheizt wird und die von der Halbleiterscheibe emittierte Wärmestrahlung Strahlungsanteile besitzt, die von den IR-Strahlem stammen, und wobei das Pyrometer mit einer Einheit in Verbindung steht, die die Strahlungs-Temperatur der registrierten Wärmestrahlung bestimmt und ein Signal erzeugt, falls die Strahlungs-Temperatur der registrierten Wärmestrahlung zeitlich so stark schwankt, daß die Schwankungsbreite außerhalb eines als zulässig angesehenen Schwankungsbereiches ΔT liegt.

6. Vorrichtung nach Anspruch 5, dadurch gekennzeichnet, daß das Pyrometer Wärmestrahlung mit einer Wellenlänge im Bereich von 0,7 bis 1,1 µm registriert.

7. Vorrichtung nach Anspruch 5 oder Anspruch 6, gekennzeichnet durch einen Manipulator, der durch das Signal aktiviert wird und daraufhin in die Quarzkammer einfährt, die Halbleiterscheibe aufnimmt und sie auf die Auflage so zurücklegt, daß sie eine gewünschte Lage einnimmt.

8. Vorrichtung nach einem der Ansprüche 5 bis 7, gekennzeichnet durch ein Aufzeichnungsgerät, das die registrierte Strahlungs-Temperatur als Funktion der Zeit graphisch darstellt.

## Claims

1. Method for detecting an incorrect position of a semiconductor wafer during a high-temperature treatment of the semiconductor wafer in a heated quartz chamber, the semiconductor wafer lying on a rotating susceptor and being held at a specific temperature with the aid of a control system, and thermal radiation being recorded using a pyrometer, in which case
a)the quartz chamber is heated by IR radiators, and thermal radiation which is emitted by the semiconductor wafer and has radiation components which originate from the IR radiators is recorded using the pyrometer;
b)the radiation temperature of the recorded thermal radiation is determined; and
c)the semiconductor wafer is assumed to be in an incorrect position if the radiation temperature of the recorded thermal radiation fluctuates to such an extent over the course of time that the fluctuation width lies outside a fluctuation range ΔT which is regarded as permissible.

2. Method according to Claim 1, characterized in that the pyrometer is used to record thermal radiation with a wavelength in the range from 0.7 to 1.1 µm.

3. Method according to Claim 1 or 2, characterized in that the fluctuation range ΔT which is regarded as permissible corresponds to a natural fluctuation range which is established when the semiconductor wafer is lying in the planned position on the susceptor.

4. Method according to one of Claims 1 to 3, characterized in that the high-temperature treatment is interrupted in the event of the semiconductor wafer being in an incorrect position, the semiconductor wafer is moved into a desired position on the susceptor, and the high-temperature treatment is continued.

5. Device for detecting an incorrect position of a semiconductor wafer during a high-temperature treatment of the semiconductor wafer in a heated quartz chamber, in which the semiconductor wafer is lying on a rotating susceptor and is held at a specific temperature by means of a control system, comprising a pyrometer for recording thermal radiation which is emitted by the semiconductor wafer, in which case the quartz chamber is heated by IR radiators, and the thermal radiation emitted by the semiconductor wafer has radiation components which originate from the IR radiators, and the pyrometer is connected to a unit which determines the radiation temperature of the recorded thermal radiation and generates a signal if the radiation temperature of the recorded thermal radiation fluctuates to such an extent over the course of time that the fluctuation width lies outside a fluctuation range ΔT which is regarded as permissible.

6. Device according to Claim 5, characterized in that the pyrometer records thermal radiation with a wavelength in the range from 0.7 to 1.1 µm.

7. Device according to Claim 5 or Claim 6, characterized by a manipulator which is activated by the signal and then enters the quartz chamber, picks up the semiconductor wafer and puts it back on the susceptor in such a way that it assumes a desired position.

8. Device according to one of Claims 5 to 7, characterized by a recording appliance which illustrates as a graph the recorded radiation temperature as a function of time.

## Revendications

1. Méthode pour détecter une erreur de positionnement d'une plaquette semi-conductrice pendant un traitement à haute température de la plaquette semi-conductrice dans une chambre en quartz chauffée, la plaquette semi-conductrice se trouvant sur un support rotatif et étant maintenue à une température définie à l'aide d'un système de régulation, et le rayonnement thermique étant enregistré par un pyromètre, dans laquelle
a) la chambre en quartz est chauffée par rayons infrarouges et le rayonnement thermique, émis par la plaquette semi-conductrice et possédant des composantes de rayonnement provenant des rayons infrarouges, est enregistré par le pyromètre ;
b) la température de rayonnement du rayonnement thermique est déterminée ; et
c) une erreur de positionnement de la plaquette semi-conductrice est admise dans le cas où la température de rayonnement du rayonnement thermique enregistré fluctue dans le temps avec une intensité telle que l'amplitude de la fluctuaction se situe à l'extérieur d'une plage de fluctuaction ΔT considérée comme acceptable.

2. Méthode selon la revendication 1, caractérisée en ce qu'on enregistre avec le pyromètre, un rayonnement thermique avec une longueur d'onde dans la plage de 0,7 à 1,1 µm.

3. Méthode selon la revendication 1 ou 2, caractérisée en ce que la plage de fluctuaction ΔT considérée comme acceptable correspond à une plage de fluctuaction naturelle qui s'instaure lorsque la plaquette semi-conductrice se trouve comme prévu sur le support.

4. Méthode selon l'une des revendications 1 à 3, caractérisée en ce que le traitement à haute température est interrompu dans le cas d'une erreur de positionnement de la plaquette semi-conductrice, la plaquette semi-conductrice est amenée sur le support dans une position donnée et le traitement à haute température est poursuivi.

5. Dispositif pour détecter une erreur de positionnement d'une plaquette semi-conductrice pendant un traitement à haute température de la plaquette semi-conductrice dans une chambre en quartz chauffée dans laquelle la plaquette semi-conductrice se trouve sur un support rotatif et est maintenue à une température définie à l'aide d'un système de régulation, comportant un pyromètre pour l'enregistrement du rayonnement thermique émis par la plaquette semi-conductrice, dans lequel la chambre en quartz est chauffée par rayons infrarouges et le rayonnement thermique émis par la plaquette semi-conductrice possède des composantes de rayonnement provenant des rayons infrarouges et le pyromètre est relié à une unité qui détermine la température de rayonnement du rayonnement thermique enregistré et qui génère un signal dans le cas où la température de rayonnement du rayonnement thermique enregistré fluctue dans le temps avec une intensité telle que l'amplitude de la fluctuaction se situe à l'extérieur d'une plage de fluctuaction ΔT considérée comme acceptable.

6. Dispositif selon la revendication 5, caractérisé en ce que le pyromètre enregistre le rayonnement thermique avec une longueur d'onde dans la plage de 0,7 à 1,1 µm.

7. Dispositif selon la revendication 5 ou la revendication 6, caractérisé par un manipulateur qui est activé par le signal et qui pénètre ensuite dans la chambre en quartz, prend la plaquette semi-conductrice et la remet sur le support de telle sorte qu'elle occupe une position souhaitée.

8. Dispositif selon l'une des revendications 5 à 7, caractérisé en ce qu'un appareil enregistreur représente graphiquement la température de rayonnement enregistrée en fonction du temps.
